# FASCICULE DE BREVET EUROPEEN

(11) **EP 2 874 191 B1**
(45) Date de publication et mention de la délivrance du brevet: **08.05.2019**
(21) Numéro de dépôt: 14193383.8
(22) Date de dépôt: 17.11.2014
(51) Int. Cl.: H01L 35/30, H01L 35/32

(54) **Dispositif hybride comprenant un module thermo électrique, notamment destiné à générer un courant électrique dans un véhicule automobile, et un échangeur de chaleur de chaleur**
Hybridvorrichtung, die ein thermoelektrisches Modul umfasst, insbesondere zur Stromerzeugung in einem Kraftfahrzeug, und Wärmetauscher
Hybrid device including a thermoelectric module, in particular intended for generating an electric current in a motor vehicle, and a heat exchanger

(30) Priorité: 18.11.2013 FR 1361255
(43) Date de publication de la demande: 20.05.2015
(73) Titulaire: Valeo Systemes Thermiques, 78320 Le Mesnil-Saint-Denis (FR)
(72) Inventeur: Azzouz, Kamel, 75012 PARIS (FR); De Pelsemaeker, Georges, 78125 POIGNY-LA-FORET (FR)
(74) Mandataire: Metz, Gaëlle

(56) Documents cités:
- EP-A1- 2 541 634
- WO-A1-2011/082922
- FR-A1- 2 965 402
- US-A- 3 178 895

## Description

La présente invention concerne un dispositif hybride comprenant un module thermo électrique, notamment destiné à générer un courant électrique dans un véhicule automobile et un échangeur de chaleur.

Il a déjà été proposé des échangeurs de chaleur comprenant, au niveau d'une première zone, des éléments, dits thermo électriques, permettant de générer un courant électrique en présence d'un gradient de température entre deux de leurs faces opposées selon le phénomène connu sous le nom d'effet Seebeck. L'échangeur est configuré pour être situé au niveau d'une face avant de véhicule de façon à pouvoir être traversé par le flux d'air circulant à travers une calandre du véhicule. L'échangeur comprend alors un empilement d'ailettes, dont un groupe est destiné à être traversé par l'air ambiant, et un autre groupe est lié thermiquement à des tubes, destinés à la circulation d'un fluide d'une boucle de refroidissement du moteur du véhicule. Les éléments thermo électriques sont pris en sandwich entre les ailettes de chaque groupe et les tubes de façon à être soumis à un gradient de température provenant de la différence de température entre les

Les documents WO2011/082922, US3178895, EP2541634 et FR2965402 décrivent des dispositifs thermo électriques.

De tels dispositifs peuvent comprendre, au niveau d'une deuxième zone, une partie dépourvue d'éléments thermo électriques de manière à permettre un échange de chaleur entre l'air ambiant et le fluide de refroidissement. La première et la deuxième zone sont alors situées l'une à coté de l'autre de sorte que l'air ambiant traverse les deux zones en parallèle.

Une telle configuration est peu adaptée à l'exploitation de la chaleur offerte par des gaz d'échappement, en particulier des gaz d'échappement recirculés.

L'invention vise à améliorer la situation et concerne à cet effet un dispositif hybride selon la revendication 1.

Ainsi, grâce au positionnement de la première zone en série par rapport à la deuxième zone selon la direction de circulation du fluide chaud, il est possible de décoreller la profondeur utilisée pour la première zone, c'est-à-dire la zone présentant des élément thermo électriques et la profondeur de la deuxième zone, c'est-à-dire, la zone dédiée à l'échange de chaleur. La première zone sera par ailleurs présente sur toute la surface latérale du dispositif, c'est-à-dire une surface perpendiculaire à la première direction, ce qui permettra de lui dédier tout le débit du fluide chaud. La direction unique donnée au fluide chaud permet en outre de limiter les pertes de charges, ce qui facilitera l'utilisation dudit dispositif sur une plus grande plage de fonctionnement moteur dans le cas d'application à des gaz d'échappement.

Selon d'autres caractéristiques de l'invention qui peuvent être prises ensemble ou séparément :
- le circuit froid comprend une première partie parcourant la première zone du dispositif et une deuxième partie parcourant la deuxième zone du dispositif
- la première zone est située en amont de la deuxième zone selon la première direction ;
- la première partie du circuit froid est en amont de la deuxième partie du circuit froid par rapport à la circulation du fluide froid ;
- la première zone est isolée thermiquement et/ou électriquement de la deuxième zone ;
- le dispositif hybride comprend des surfaces d'échange secondaire avec le fluide chaud situées au niveau de la première zone et de la deuxième zone, les surfaces d'échange secondaire situées au niveau de la première zone étant indépendante thermiquement et/ou électriquement des surfaces d'échange secondaire situées au niveau de la deuxième zone ;
- le circuit chaud et le circuit froid sont agencés de sorte que le fluide chaud circule transversalement au fluide froid dans le dispositif hybride ;
- ledit élément thermo électrique est de forme annulaire ;
- une première desdites faces actives définie par une surface de périphérie extérieure de l'élément thermo électrique est en relation d'échange thermique avec le fluide chaud et une deuxième desdites faces actives définie par une surface de périphérie intérieure de l'élément thermo électrique est en relation d'échange thermique avec le fluide froid.;
- une première partie du circuit froid parcourant la première zone du dispositif et une deuxième partie du circuit froid parcourant la deuxième zone du dispositif sont indépendantes ;
- le dispositif hybride comprend une boite collectrice d'entrée du fluide froid dans la première partie du circuit froid, une boite collectrice de sortie du fluide froid de la première partie du circuit froid, une boite collectrice d'entrée du fluide froid dans la deuxième partie du circuit froid et une boite collectrice de sortie du fluide froid de la deuxième partie du circuit froid, la première partie du circuit froid et/ou la deuxième partie du circuit froid comprenant plusieurs sous-circuits de passage du fluide froid entre la boite collectrice d'entrée et la boite collectrice de sortie de la première partie du circuit froid et/ou entre la boite collectrice d'entrée et la boite collectrice de sortie de la deuxième partie du circuit froid, les sous-circuits de passage étant parallèles les uns des autres;
- la première partie du circuit froid et la deuxième partie du circuit froid comprennent le même nombre de sous-circuits de passage ;
- une première partie du circuit froid parcourant la première zone du dispositif et une deuxième partie du circuit froid parcourant la deuxième zone du dispositif sont destinées à être parcourues en série, dans cet ordre.;
- le dispositif comprend une boite collectrice d'entrée du fluide froid dans le dispositif hybride et une boite collectrice de sortie du fluide froid du dispositif hybride, le circuit froid comprenant plusieurs sous-circuits de passage du fluide froid dans la première zone et dans la deuxième zone entre la boite collectrice d'entrée et la boite collectrice de sortie, les sous-circuits étant parallèles les uns des autres ;
- la boite collectrice d'entrée du fluide froid est située au niveau d'un module d'éléments thermo électriques destiné à entrer en contact en premier avec ledit fluide chaud, et la boite collectrice de sortie du fluide froid est située au niveau d'une section de la deuxième zone destinée à entrer en contact en dernier avec ledit fluide chaud ;
- la boite collectrice d'entrée et la boite collectrice de sortie du fluide froid sont situées d'un même coté du dispositif hybride ;
- les éléments thermo électriques sont regroupés en modules, disposées transversalement à ladite première direction ;
- au moins deux desdits modules forment un rang de modules dans lequel lesdits modules sont espacés l'un de l'autre selon la première direction ;
- au moins deux desdits modules forment une rangée de modules dans laquelle lesdits modules sont espacés l'un de l'autre selon une deuxième direction, transversale à la première direction ;
- le circuit froid comprend des tubes au niveau de ladite première et/ou de ladite deuxième zone dudit dispositif, formant une rangée de tubes dans laquelle au moins deux desdits tubes sont espacés les uns des autres selon la deuxième direction ;
- la deuxième direction est perpendiculaire à la première direction et à une direction de circulation du fluide froid dans le dispositif hybride ;
- le dispositif hybride comprend au moins deux rangs et au moins deux rangées de modules ;
- deux rangées de modules sont espacées entre elles selon la première direction et deux rangs de modules sont espacés entre eux selon la deuxième direction ;
- les modules voisins de deux rangées adjacentes sont décalés l'un par rapport à l'autre selon la deuxième direction de sorte à être disposés en quinconce ;
- les modules voisins de deux rangées adjacentes sont situés au même niveau l'un par rapport à l'autre selon la deuxième direction de sorte à être disposés selon un quadrillage ;
- les modules voisins de deux rangs adjacents sont décalés l'un par rapport à l'autre selon la première direction de sorte à être disposés en quinconce ;
- les modules voisins de deux rangs adjacents sont situés au même niveau selon la première direction de sorte à être disposés selon un quadrillage
- chacun des sous-circuits de passage comprend les modules voisins de chacune des rangées ;
- chacun des sous-circuits de passage relie successivement les rangées voisines en serpentin
- chacun des sous-circuits de passage comprennent des tubulures raccordant entre eux les modules voisins de deux rangées différentes, à leurs extrémités ;
- les surfaces d'échange secondaire sont des ailettes ondulées et/ou perforées et/ou à persiennes ;
- ledit élément thermo électrique présente deux faces planes parallèles opposées reliant leurs faces actives ;
- les surfaces d'échange secondaire sont traversées par lesdits éléments thermo électriques ;
- les surfaces d'échange secondaire s'étendent dans des plans parallèles au sens de circulation du fluide chaud ;
- les surfaces d'échange secondaire comprennent un revêtement catalytique pour assurer une conversion catalytique de composants toxiques du fluide chaud ;
- lesdites surfaces d'échange secondaires relient tout ou partie des modules entre eux de sorte qu'elles sont traversées par lesdits modules.
- ledit dispositif hybride est configuré pour être positionné dans un conduit de gaz d'échappement recirculés de véhicule automobile de sorte que lesdites surfaces d'échange secondaire soient balayées par lesdits gaz, ces derniers définissants ledit fluide chaud.

L'invention sera mieux comprise à la lumière de la description suivante qui n'est donnée qu'à titre indicatif et qui n'a pas pour but de la limiter, accompagnée des dessins joints parmi lesquels :
- les figures 1 et 2 illustrent de façon schématique, en perspective, des étapes de montage d'un exemple de module d'éléments thermo électriques d'un dispositif hybride conforme à l'invention,
- les figures 3 et 4 illustrent de façon schématique, en perspective, des exemples de réalisation d'un faisceau d'une première zone d'un dispositif hybride conforme à l'invention,
- la figure 5 illustre en perspective un exemple de dispositif hybride conforme à l'invention,
- la figure 6 illustre de façon schématique, en coupe, une première et une deuxième zone du dispositif hybride de la figure 5 ;
- la figure 7 illustre de façon schématique, en perspective, un exemple de circuit de circulation de l'un des fluides parcourant le dispositif hybride illustré à la figure 5,
- la figure 8 illustre de façon schématique, en perspective, une rangée de modules d'un dispositif hybride conforme à l'invention.

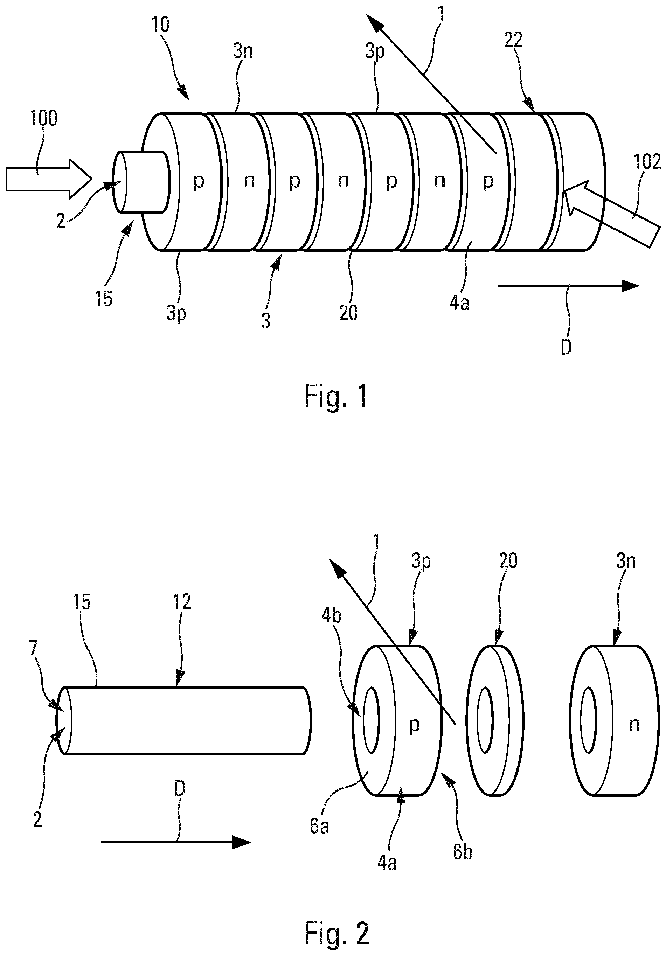

L'invention concerne un dispositif hybride comprenant des éléments thermo électriques formant ici au moins un module thermo électrique 10 dont un exemple est illustré aux figures 1 et 2. Ledit module 10 comprend ici un élément d'un premier circuit 1, dit chaud, apte à permettre la circulation d'un premier fluide, dit chaud, notamment des gaz d'échappement d'un moteur, et un élément 15 d'un second circuit 2, dit froid, apte à permettre la circulation d'un second fluide, dit froid, notamment un fluide caloporteur d'un circuit de refroidissement, de température inférieure à celle du fluide chaud.

Ledit fluide froid pourra présenter un coefficient d'échange thermique supérieur audit fluide chaud, notamment en étant prévu liquide.

Les éléments thermo électriques sont, par exemple, de forme annulaire. Ils sont susceptibles de générer un courant électrique sous l'action d'un gradient de température exercé entre deux de leurs faces, l'une 4a, dite première face, étant définie par une surface de périphérie extérieure, cylindrique, et l'autre 4b, dite deuxième face, étant définie par une surface de périphérie intérieure, cylindrique. Lesdites première et deuxième faces 4a, 4b sont, par exemple, de section circulaire. De façon plus générale, toute section de forme arrondie et/ou polygonale est possible. Ici, la première face 4a est en relation d'échange thermique avec le circuit chaud et la deuxième face 4b est en relation d'échange thermique avec le circuit froid.

De tels éléments fonctionnent, selon l'effet Seebeck, en permettant de créer un courant électrique dans une charge connectée entre lesdites faces 4a, 4b soumises au gradient de température. De façon connue de l'homme du métier, de tels éléments sont constitués, par exemple, de Bismuth et de Tellurium (Bi₂Te₃).

Les éléments thermo électriques pourront être, pour une première partie, des éléments 3p d'un premier type, dit P, permettant d'établir une différence de potentiel électrique dans un sens, dit positif, lorsqu'ils sont soumis à un gradient de température donné, et, pour l'autre partie, des éléments 3n d'un second type, dit N, permettant la création d'une différence de potentiel électrique dans un sens opposé, dit négatif, lorsqu'ils sont soumis au même gradient de température.

Aux figures 1 et 2, les éléments thermo électrique 3 représentés sont constitués d'un anneau en une seule pièce. Ils pourront cependant être formés de plusieurs pièces formant chacune une portion angulaire de l'anneau.

La première surface 4a présente, par exemple, un rayon compris entre 1,5 et 4 fois le rayon de la deuxième surface 4b. Il pourra s'agir d'un rayon égal à environ 2 fois celui de deuxième surface 4b.

Ledit élément thermo électrique présente, par exemple, deux faces planes 6a, 6b parallèles opposées. Autrement dit, l'anneau constituant l'élément thermo électrique est de section annulaire rectangulaire.

Lesdits éléments thermo électriques 3 sont disposés, par exemple, dans le prolongement longitudinal l'un de l'autre, notamment de façon coaxiale, et les éléments thermo électriques de type P alternent avec les éléments thermo électriques de type N, selon une direction D, dite troisième direction D. Ils sont, notamment, de forme et de dimension identiques. Ils pourront cependant présenter une épaisseur, c'est-à-dire une dimension entre leurs deux faces planes, différente d'un type à l'autre, notamment en fonction de leur conductivité électrique.

Lesdits éléments thermo électriques 3 sont, par exemple, groupés par paire, chaque paire étant formée d'un dit élément thermo électrique de type P et d'un dit élément thermo électrique de type N, et ledit module est configuré pour permettre une circulation de courant entre les premières surfaces des éléments thermo électriques d'une même paire et une circulation de courant entre les deuxièmes surfaces de chacun des éléments thermo électriques de ladite même paire et l'élément thermo électrique voisin de la paire voisine. On assure de la sorte une circulation en série du courant électrique entre les éléments thermo électriques 3 disposés les uns à côtés des autres selon la direction D.

Pour faciliter la configuration des circuits de circulation de fluide 1, 2, on pourra prévoir que lesdits éléments thermo électriques 3 soient disposés les uns par rapport aux autres de façon à ce que leur première et/ou deuxième surface 4a, 4b soient dans le prolongement l'une de l'autre. Lesdites première et/ou deuxième surfaces 4a, 4b sont ainsi inscrites, par exemple, dans une surface générée par une droite.

Ledit élément 15 du circuit froid 2 de circulation de liquide froid est au contact de ladite deuxième surface 4b desdits éléments thermo électriques 3. Ledit élément 15 du circuit froid 2 est, par exemple, de section circulaire.

A la figure 2, on constate que ledit module comprend des tubes, dits premiers tubes 12, de circulation de liquide froid dans ledit élément du circuit froid. Au moins deux éléments thermo électriques de type différent sont montés sur lesdits premiers tubes 12. Les premiers tubes 12 sont, notamment, métalliques. Ils définissent au moins en partie une première partie 7 du circuit froid 2.

Ledit module 10 pourra comprendre en outre des moyens d'isolation électrique 20 disposés entre deux faces 6a, 6b en vis-à-vis d'éléments thermo électriques voisins 3 selon la troisième direction D correspondant à la direction d'extension longitudinale du premier tube 12. A la figure 2, les éléments thermo électriques 3, et les moyens d'isolation électrique 20 sont assemblés, de façon alternée, sur les premiers tubes 12 de circulation de fluide froid.

Ledit module pourra en outre comprendre des premiers moyens de connexion électrique reliant les surfaces de périphérie extérieure 4a de deux desdits éléments thermo électrique, prévus adjacents et de types différents et des seconds moyens de connexion électrique reliant les surfaces de périphérie intérieur 4b de deux desdits éléments thermo électrique, prévus adjacents et de types différents.

Cela étant, de façon générale, comme illustré à la figure 1, ledit module est configuré de manière à ce que le circuit chaud permette d'établir un échange thermique entre ladite première face 4a et le fluide chaud, circulant ici à l'extérieur desdits éléments thermo électrique 3 dans le circuit chaud 1, selon la flèche illustrée 102 et de sorte que le circuit froid permette d'établir un échange thermique entre ladite deuxième face 4b et le fluide froid, circulant ici dans la première partie 7 du circuit froid 2 selon la flèche illustré 100. Dans le cas d'éléments thermo électriques, on favorise ainsi l'échange entre les éléments thermo électriques 3, et le fluide présentant le coefficient d'échange thermique le plus faible, ici, les gaz d'échappement.

Ledit module est en outre ici configuré pour que, au niveau dudit module, ledit fluide chaud et ledit second fluide circulent de manière transversale, notamment orthogonale, l'un par rapport à l'autre, tel que cela est illustré par l'orientation des flèches 100, 102. Une telle configuration favorise l'intégration du module dans son environnement en diminuant par ailleurs les quantités de matière engagées.

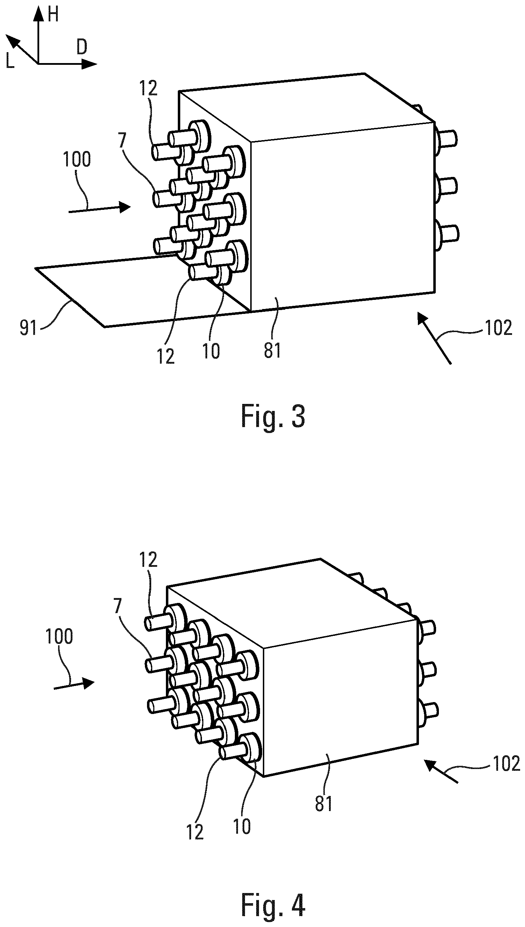

Un faisceau du dispositif hybride de l'invention comprenant, au niveau d'une première zone 91, une pluralité desdits modules 10 est illustré aux figures 3 et 4. Un tel dispositif hybride comprend au moins deux desdits modules 10 formant un rang de modules et au moins deux desdits modules formant une rangée de modules.

Les modules 10 appartenant à un même rang de modules sont espacés les uns des autres selon une première direction L et situés au même niveau selon une deuxième direction H transversale à la première. Les modules 10 appartenant à une même rangée de modules sont espacés les uns des autres selon la deuxième direction H et situés au même niveau selon la première direction L. On peut noter que le dispositif est agencé pour que le fluide chaud le traverse en parcourant une seule direction, c'est-à-dire ici la première direction L si ce n'est pour contourner lesdits modules 10. La première direction L est notamment parallèle à la direction de circulation du fluide chaud 102 dans le dispositif hybride et la deuxième direction H est perpendiculaire à la première direction L et à la direction de circulation du fluide froid 100 dans le dispositif hybride. Les modules 10 s'étendent ainsi dans le dispositif selon la troisième direction D et sont disposées en rang selon la première direction L et en rangée selon la deuxième direction H.

La première direction L, la deuxième direction H et/ou la troisième direction D sont par exemple perpendiculaires entre elles comme illustré sur les figures 3 et 4.

Dans l'exemple illustré à la figure 3, les modules 10 voisins de deux rangées adjacentes sont décalés l'un par rapport à l'autre selon la deuxième direction H en plus d'être décalé selon la première direction L de sorte à être disposés en quinconce. On appelle modules 10 voisins de deux rangées adjacentes, les modules 10 qui ont la même position dans leurs rangées respectives, c'est-à-dire les premiers modules des rangées en partant du bas selon la deuxième direction H, les modules situés juste au dessus des premiers modules etc..

Selon l'exemple de réalisation de l'invention illustré à la figure 3, la première zone 91 du dispositif de l'invention comprend quatre rangées de trois modules 10 et six rangs de deux modules 10. Il pourrait bien sûr comprendre un nombre différents de rangées et/ou de rang ainsi que de modules 10 par rangées et/ou de modules 10 par rang.

Dans l'exemple de réalisation illustré à la figure 4, les modules 10 voisins de deux rangées adjacentes sont situés au même niveau l'un par rapport à l'autre selon la deuxième direction H de sorte à être disposés selon un quadrillage. Les modules 10 voisins de deux rangs adjacents sont situés au même niveau selon la première direction L de sorte à être disposés selon un quadrillage. Ainsi, le nombre de modules 10 que comprend une rangée est égale au nombre de rangs et le nombre de modules 10 que comprend un rang est égale au nombre de rangées. Dans cet exemple, la première zone 91 du dispositif comprend quatre rangées de trois modules 10 chacune et trois rangs de quatre modules 10 chacun mais il pourrait bien sûr comprendre un nombre différents de rangées et/ou de rangs ainsi que de modules 10 par rangées et/ou de modules 10 par rang.

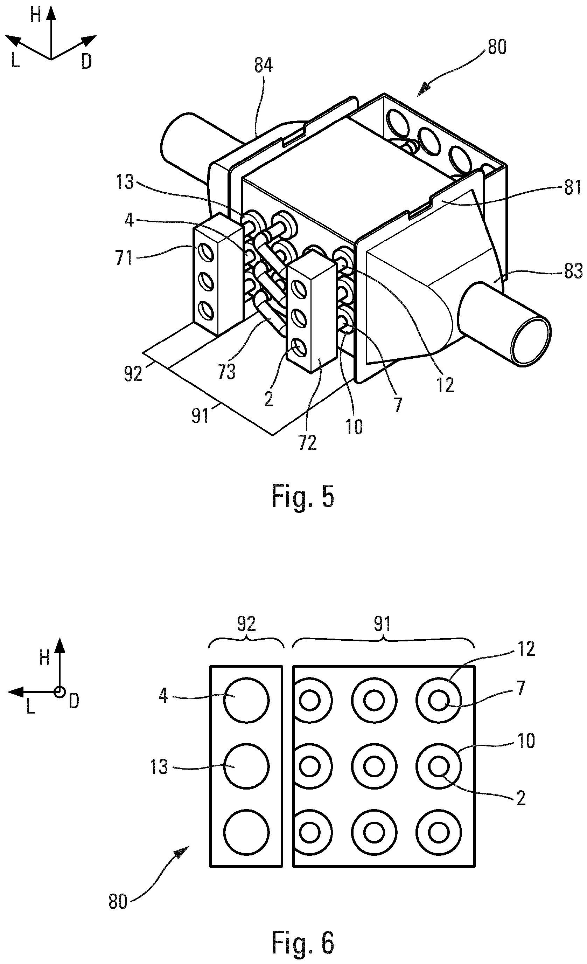

Le dispositif hybride 80 comprend une deuxième zone 92 permettant un échange de chaleur entre le fluide froid et le fluide chaud comme illustré sur les figures 5 et 6. Le dispositif 80 selon l'invention présente ainsi une fonction de générateur d'électricité au niveau de sa première zone 91 et d'échangeur de chaleur au niveau de sa deuxième zone 92. Ladite première zone 91 et ladite deuxième zone 92 sont situées en série selon la première direction L. En particulier la première zone 91 est située en amont de la deuxième zone 92 selon le sens de circulation du fluide chaud, c'est-à-dire selon la première direction L.

On remarque ici que le circuit chaud et le circuit froid sont agencés de sorte que le fluide chaud circule transversalement au fluide froid dans le dispositif hybride, en particulier dans ladite première zone 91.

Ladite deuxième zone 92 comprend une deuxième partie 4 du circuit froid. Autrement dit, ledit circuit chaud et la deuxième partie 4 dudit circuit froid sont directement en contact de manière à permettre un échange thermique entre le fluide froid et le fluide chaud. La deuxième partie du circuit froid comprend, par exemple des tubes, dits deuxièmes tubes 13, de circulation du fluide froid.

La première zone 91 comprend ici plusieurs rangées de modules 10 et plusieurs rangs de module 10. La deuxième zone 92 comprend ici une unique rangée de tubes 13, lesdits deuxièmes tubes 13 étant espacées entre eux selon la deuxième direction H et situé au niveau d'une face du dispositif par laquelle le fluide chaud sort du dispositif. Les tubes 13 forment ainsi une rangée de tubes 13 dans laquelle au moins deux desdits tubes 13, ici trois tubes 13, sont espacés les uns des autres selon la deuxième direction H, préférentiellement selon le même écartement que celui des deuxièmes tubes 13 de la première zone 91. La deuxième zone 92 comprend ici une unique rangée de tubes 13 mais elle pourrait bien sûr comprendre un nombre différents de tubes 13.

Le dispositif hybride 80 selon l'invention pourra comprendre une boite collectrice d'entrée 72 du fluide froid dans le dispositif 80 et une boite collectrice de sortie 71 du fluide froid du dispositif, le circuit froid comprenant plusieurs sous-circuits 73 de passage du fluide froid à travers les modules 10 entre la boite collectrice d'entrée 72 et la boite collectrice de sortie 71, les sous circuits 73 étant parallèles les uns des autres.

On remarque ici que la première partie 7 du circuit froid et la deuxième partie 4 du circuit froid sont liées. En particulier, les sous circuits 73 de la première partie 7 du circuit froid et les sous circuits 73 de la deuxième partie 4 du circuit froid communiquent entre eux de sorte que c'est le même fluide qui entre dans le dispositif par la boite collectrice d'entrée 72, parcourt la première partie 7 du circuit froid, la deuxième partie 4 du circuit froid et sort du dispositif par la boite collectrice de sortie 71 comme visible sur la figure 5.

La boite collectrice de sortie 71 du fluide froid est ici située au niveau de la deuxième zone 91 et la boite collectrice d'entrée 72 du fluide froid est ici située au niveau de la rangée de modules 10 destinée à entrer en contact en premier avec ledit fluide chaud, c'est-à-dire la rangée de modules 10 située le plus près de la face d'entrée 81. La boite collectrice d'entrée 72 et la boite collectrice de sortie 71 sont situées d'un même coté du dispositif, ici un coté latéral du dispositif par rapport à la face d'entrée du fluide chaud dans le dispositif.

Chacun des sous-circuits de passage 73 comprend les modules 10 voisins de chacune des rangées. Ainsi il y a autant de sous-circuit indépendant que de modules 10 par rangée. Chacun des sous-circuits 73 relie ici successivement les rangées voisines en serpentin. Le fluide froid arrive dans la boite collectrice d'entrée 72, entre dans un des modules 10 de la rangée située au niveau de la boite collectrice d'entrée 72, c'est-à-dire qu'il entre dans la première partie 7 du circuit froid, le traverse dans le sens de la longueur selon la troisième direction D comme vu précédemment, passe dans un module 10 voisin d'une rangée adjacente et le traverse selon la même direction mais en sens opposé. Le fluide froid continue son trajet jusqu'à atteindre le tube voisin de la rangée de tube 13 de la deuxième zone 92, c'est-à-dire jusqu'à atteindre la deuxième partie 4 du circuit froid située dans la deuxième zone, avant de sortir du dispositif hybride par la boite collectrice de sortie 71. On comprend ici que la première partie 7 du circuit froid est en amont de la deuxième partie 4 du circuit froid par rapport à la circulation du fluide froid.

Selon une variante de l'invention illustrée figure 6, la première partie 7 du circuit froid et la deuxième partie 4 du circuit froid sont indépendantes thermiquement. On comprend ici que le dispositif est agencé pour faire circuler le fluide froid dans la première zone 91 et dans la deuxième zone de manière indépendante.

Les sous-circuits de la première partie 7 du circuit froid sont alors indépendants des sous-circuits de la deuxième partie 4 du circuit froid. Chacune des zones comprendra sa propre boite collectrice d'entrée du fluide froid et sa propre boite collectrice de sortie du fluide froid similaires à celle décrites précédemment. La première partie 7 du circuit froid et la deuxième partie 4 du circuit froid comprennent ici le même nombre de sous-circuits de passage.

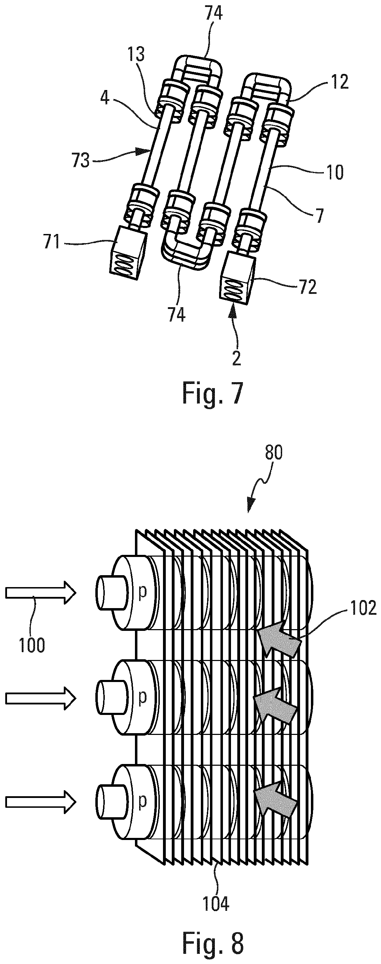

Comme visible de manière plus détaillée à la figure 7, les sous circuits 73 de passage comprennent des tubulures 74 raccordant entre eux les modules 10 voisins de deux rangées différentes, à leurs extrémités. Ces tubulures ont notamment la forme d'un U.

Le dispositif hybride selon l'invention comprend également une boite collectrice d'entrée 83 du fluide chaud dans le dispositif située en vis-à-vis de la face d'entrée du fluide chaud à travers les modules 10, et une boite collectrice de sortie 84 du fluide chaud, située à l'opposé de la boite collectrice d'entrée 83 du fluide chaud dans le dispositif hybride.

Comme illustré à la figure 8, chacun des modules peut comprendre avantageusement des surfaces d'échange secondaire 9, en particulier des ailettes 104, avec le fluide chaud. On augmente de la sorte la surface d'échange entre les éléments thermo électriques 3 et ledit fluide chaud. Lesdites ailettes 104 sont disposées, par exemple, transversalement, en particulier radialement auxdits éléments thermo électriques 3. Elles sont ici positionnées parallèlement les unes aux autres avec un écartement permettant un bon échange de chaleur avec le fluide chaud tout en limitant les pertes de charges. Lesdites ailettes 104 pourront être décentrées par rapport auxdits éléments thermo électriques 3, notamment allongées du côté de l'arrivée du fluide chaud. Lesdites ailettes 104 sont par exemple ondulées, perforées et/ou à persiennes. Le fait que les ailettes soient ondulées et/ou perforées et/ou à persiennes permet d'améliorer l'échange thermique, notamment en augmentant les surfaces d'échanges et en perturbant l'écoulement du fluide chaud. Les ailettes sont, notamment, en métal.

Lesdites ailettes 104 relient avantageusement les modules entre eux de sorte qu'elles sont traversées par lesdits modules. Sur ces figures, une seules desdites rangées est illustrée. Elles peuvent également relier entre eux les tubes 13 de la deuxième partie du circuit froid.

D'un point de vue électrique, les modules pourront être connectés entre eux en série et/ou en parallèle, par des connexions, non représentées, situées à leurs extrémités longitudinales.

Lesdites surfaces d'échange secondaire 9 pourront comprendre un revêtement catalytique pour assurer une conversion catalytique de composants toxiques du fluide chaud. Dans le cas de gaz d'échappement, ledit module pourra de la sorte équiper un pot catalytique en complément ou substitution des composants servant classiquement à la catalyse dans de tels équipements.

Selon l'exemple de réalisation de la figure, les surfaces d'échange secondaire de la première zone et celle de la deuxième zone sont indépendantes thermiquement et électriquement.

Comme déjà évoqué, un tel dispositif pourra être configuré pour être positionnée dans un conduit de gaz d'échappement de véhicule automobile de sorte que lesdites surfaces d'échange secondaire soient balayées par lesdits gaz. Autrement dit, les gaz sont destinés à être canalisés à travers les ailettes par le conduit de gaz d'échappement lui-même tandis que la circulation du second fluide pourra se faire par les boites collectrices d'entrée/sortie positionnée latéralement, d'où une grande simplicité d'intégration.

## Revendications

1. Dispositif hybride (80) comprenant, au niveau d'une première zone (91), des éléments thermo électriques (3) permettant la génération d'un courant électrique à partir d'un gradient de température appliqué entre deux de ses faces actives (4a, 4p), ledit dispositif comprenant un premier circuit (1), dit chaud, apte à permettre la circulation d'un premier fluide, dit chaud, et un deuxième circuit (2), dit froid, apte à permettre la circulation d'un deuxième fluide, dit froid, de température inférieure à celle du fluide chaud de façon à créer ledit gradient, ledit dispositif hybride (80) comprenant une deuxième zone (92), ladite deuxième zone comprend une deuxième partie (4) du circuit froid, dans laquelle ledit circuit chaud et la deuxième partie dudit circuit froid sont directement en contact de manière à permettre un échange thermique entre le fluide froid et le fluide chaud, ledit dispositif hybride (80) étant agencé pour que le fluide chaud le traverse en parcourant une seule direction, dite première direction (L), ladite première zone (91) et ladite deuxième zone (92) étant situées en série selon la première direction (L), dans lequel les éléments thermo électriques (3) sont regroupés en modules (10), au moins deux desdits modules formant une rangée de modules (10) dans laquelle lesdits modules sont espacés l'un de l'autre, et en ce que les modules (10) voisins de deux rangées adjacentes sont décalés l'un par rapport à l'autre de sorte à être disposés en quinconce.

2. Dispositif hybride (80) selon la revendication 1, dans lequel la première zone (91) est située en amont de la deuxième zone (92) selon la première direction (L).

3. Dispositif hybride (80) selon l'une quelconque des revendications précédentes, dans lequel la première zone (91) et la deuxième zone (92) sont isolés thermiquement et/ou électriquement.

4. Dispositif hybride (80) selon l'une quelconque des revendications précédentes, dans lequel le dispositif hybride comprend des surfaces d'échange secondaire (9) avec le fluide chaud situées au niveau de la première zone (91) et de la deuxième zone (92), les surfaces d'échange secondaire (9) situées au niveau de la première zone (91) étant indépendante thermiquement et/ou électriquement des surfaces d'échange secondaire (9) situées au niveau de la deuxième zone (92).

5. Dispositif hybride (80) selon l'une quelconque des revendications précédentes, dans lequel le circuit chaud (1) et le circuit froid (2) sont agencés de sorte que le fluide chaud circule transversalement au fluide froid dans le dispositif hybride (80).

6. Dispositif hybride (80) selon l'une quelconque des revendications précédentes, dans lequel ledit élément thermo électrique (3) est de forme annulaire, une première desdites faces actives (4a) définie par une surface de périphérie extérieure de l'élément thermo électrique (3) étant en relation d'échange thermique avec le fluide chaud et une deuxième desdites faces actives (4b) définie par une surface de périphérie intérieure de l'élément thermo électrique (3) étant en relation d'échange thermique avec le fluide froid.

7. Dispositif hybride (80) selon l'une quelconque des revendications précédentes, dans lequel une première partie (7) du circuit froid (2) parcourant la première zone (91) du dispositif (80) et une deuxième partie (4) du circuit froid (2) parcourant la deuxième zone (92) du dispositif (80) sont indépendantes.

8. Dispositif hybride (80) selon la revendication 7, comprenant une boite collectrice d'entrée du fluide froid dans la première partie (7) du circuit froid (2), une boite collectrice de sortie du fluide froid de la première partie (7) du circuit froid (2), une boite collectrice d'entrée du fluide froid dans la deuxième partie (4) du circuit froid (2) et une boite collectrice de sortie du fluide froid de la deuxième partie (4) du circuit froid (2), la première partie (7) du circuit froid (2) et/ou la deuxième partie (4) du circuit froid (2) comprenant plusieurs sous-circuits de passage du fluide froid entre la boite collectrice d'entrée et la boite collectrice de sortie de la première partie (7) du circuit froid (4) et/ou entre la boite collectrice d'entrée et la boite collectrice de sortie de la deuxième partie (4) du circuit froid (2), les sous-circuits de passage étant parallèles les uns des autres.

9. Dispositif hybride (80) selon la revendication 8, dans lequel la première partie (7) du circuit froid (2) et la deuxième partie (4) du circuit froid (2) comprennent le même nombre de sous-circuits de passage.

10. Dispositif hybride (80) selon l'une quelconque des revendications 1 à 6, dans lequel une première partie (7) du circuit froid (2) parcourant la première zone (91) du dispositif (80) et une deuxième partie (4) du circuit froid (2) parcourant la deuxième zone (92) du dispositif (80) sont destinées à être parcourues en série, dans cet ordre.

11. Dispositif hybride (80) selon la revendication 10, comprenant une boite collectrice d'entrée (72) du fluide froid dans le dispositif hybride (80) et une boite collectrice de sortie (71) du fluide froid du dispositif hybride (80), le circuit froid (2) comprenant plusieurs sous-circuits de passage (73) du fluide froid dans la première zone (91) et dans la deuxième zone (92) entre la boite collectrice d'entrée (72) et la boite collectrice de sortie (71), les sous-circuits (73) étant parallèles les uns des autres.

12. Dispositif hybride (80) selon la revendication 11, dans lequel la boite collectrice d'entrée (72) du fluide froid est située au niveau d'un module (10) d'éléments thermo électriques destiné à entrer en contact en premier avec ledit fluide chaud, et la boite collectrice de sortie (71) du fluide froid est située au niveau d'une section de la deuxième zone (92) destinée à entrer en contact en dernier avec ledit fluide chaud.

13. Dispositif hybride (80) selon la revendication 12, dans lequel la boite collectrice d'entrée (72) et la boite collectrice de sortie (71) du fluide froid sont situées d'un même coté du dispositif (80).

14. Dispositif hybride (80) selon l'une quelconque des revendications précédentes, dans lequel au moins deux modules (10) d'éléments thermo électriques forment une rangée de modules (10) dans laquelle lesdits modules (10) sont espacés l'un de l'autre selon une deuxième direction (H), transversale à la première direction (L), le circuit froid (2) comprenant des tubes au niveau de ladite première et/ou deuxième zone (91, 92) dudit dispositif (80), formant une rangée de tubes dans laquelle au moins deux desdits tubes (12, 13) sont espacés les uns des autres selon la deuxième direction (H).

## Patentansprüche

1. Hybridvorrichtung (80), die an einem ersten Bereich (91) thermoelektrische Elemente (3) umfasst, welche die Erzeugung eines elektrischen Stroms anhand eines Temperaturgradienten gestatten, der zwischen zweien ihrer aktiven Seiten (4a, 4p) angewandt wird, die Vorrichtung umfassend einen ersten Kreislauf (1), der als warmer Kreislauf bezeichnet wird, der geeignet ist, die Durchströmung eines ersten Fluids zu gestatten, das als warmes Fluid bezeichnet wird, und einen zweiten Kreislauf (2), der als kalter Kreislauf bezeichnet wird, der geeignet ist, die Durchströmung eines zweiten Fluids, das als kaltes Fluid bezeichnet wird, das eine niedrigere Temperatur als jene des warmen Fluids aufweist, zu gestatten, um den Gradienten zu erzeugen, die Hybridvorrichtung (80) umfassend einen zweiten Bereich (92), der zweite Bereich einen zweiten Teil (4) des kalten Kreislaufs umfasst, wobei der warme Kreislauf und der zweite Teil des kalten Kreislaufs direkt in Kontakt stehen, um einen Wärmeaustausch zwischen dem kalten Fluid und dem warmen Fluid zu gestatten, wobei die Hybridvorrichtung (80) so angeordnet ist, dass das warme Fluid sie durchquert, indem es eine einzige Richtung durchläuft, die als erste Richtung (L) bezeichnet wird, wobei der erste Bereich (91) und der zweite Bereich (92) entlang der ersten Richtung (L) in Reihe gelegen sind, wobei die thermoelektrischen Elemente (3) in Module (10) gruppiert sind, wobei mindestens zwei der Module eine Reihe von Modulen (10) bilden, wobei die Module voneinander beabstandet sind, und dadurch, dass die benachbarten Module (10) zweier angrenzender Reihen bezogen aufeinander versetzt sind, um gestaffelt angeordnet zu sein.

2. Hybridvorrichtung (80) nach Anspruch 1, wobei der erste Bereich (91) stromauf des zweiten Bereichs (92) entlang der ersten Richtung (L) gelegen ist.

3. Hybridvorrichtung (80) nach einem der vorhergehenden Ansprüche, wobei der erste Bereich (91) und der zweite Bereich (92) thermisch und/oder elektrisch isoliert sind.

4. Hybridvorrichtung (80) nach einem der vorhergehenden Ansprüche, wobei die Hybridvorrichtung Flächen zum sekundären Austausch (9) mit dem warmen Fluid umfasst, die beim ersten Bereich (91) und zweiten Bereich (92) gelegen sind, wobei die Flächen zum sekundären Austausch (9), die beim ersten Bereich (91) gelegen sind, von den Flächen zum sekundären Austausch (9), die beim zweiten Bereich (92) gelegen sind, thermisch und/oder elektrisch unabhängig sind.

5. Hybridvorrichtung (80) nach einem der vorhergehenden Ansprüche, wobei der warme Kreislauf (1) und der kalte Kreislauf (2) so angeordnet sind, dass das warme Fluid quer zu dem kalten Fluid in der Hybridvorrichtung (80) strömt.

6. Hybridvorrichtung (80) nach einem der vorhergehenden Ansprüche, wobei das thermoelektrische Element (3) ringförmig ist, wobei eine erste der aktiven Seiten (4a), die von einer Außenumfangsfläche des thermoelektrischen Elements (3) definiert ist, in einer Wärmeaustauschbeziehung mit dem warmen Fluid steht und eine zweite der aktiven Seiten (4b), die von einer Innenumfangsfläche des thermoelektrischen Elements (3) definiert ist, in einer Wärmeaustauschbeziehung mit dem kalten Fluid steht.

7. Hybridvorrichtung (80) nach einem der vorhergehenden Ansprüche, wobei ein erster Teil (7) des kalten Kreislaufs (2), der den ersten Bereich (91) der Vorrichtung (80) durchläuft, und ein zweiter Teil (4) des kalten Kreislaufs (2), der den zweiten Bereich (92) der Vorrichtung (80) durchläuft, unabhängig sind.

8. Hybridvorrichtung (80) nach Anspruch 7, umfassend einen Sammelbehälter zum Eintritt des kalten Fluids in den ersten Teil (7) des kalten Kreislaufs (2), einen Sammelbehälter zum Austritt des kalten Fluids aus dem ersten Teil (7) des kalten Kreislaufs (2), einen Sammelbehälter zum Eintritt des kalten Fluids in den zweiten Teil (4) des kalten Kreislaufs (2) und einen Sammelbehälter zum Austritt des kalten Fluids aus dem zweiten Teil (4) des kalten Kreislaufs (2), der erste Teil (7) des kalten Kreislaufs (2) und/oder der zweite Teil (4) des kalten Kreislaufs (2) umfassend mehrere Unterkreisläufe zum Durchlass des kalten Fluids zwischen dem Sammelbehälter zum Eintritt und dem Sammelbehälter zum Austritt aus dem ersten Teil (7) des kalten Kreislaufs (4) und/oder zwischen dem Sammelbehälter zum Eintritt und dem Sammelbehälter zum Austritt aus dem zweiten Teil (4) des kalten Kreislaufs (2), wobei die Unterkreisläufe zueinander parallel sind.

9. Hybridvorrichtung (80) nach Anspruch 8, wobei der erste Teil (7) des kalten Kreislaufs (2) und der zweite Teil (4) des kalten Kreislaufs (2) dieselbe Anzahl von Unterkreisläufen zum Durchlass umfassen.

10. Hybridvorrichtung (80) nach einem der Ansprüche 1 bis 6, wobei ein erster Teil (7) des kalten Kreislaufs (2), der den ersten Bereich (91) der Vorrichtung (80) durchläuft, und ein zweiter Teil (4) des kalten Kreislaufs (2), der den zweiten Bereich (92) der Vorrichtung (80) durchläuft, dazu bestimmt sind, in Reihe in dieser Reihenfolge durchlaufen zu werden.

11. Hybridvorrichtung (80) nach Anspruch 10, umfassend einen Sammelbehälter zum Eintritt (72) des kalten Fluids in die Hybridvorrichtung (80) und einen Sammelbehälter zum Austritt (71) des kalten Fluids aus der Hybridvorrichtung (80), der kalte Kreislauf (2) umfassend mehrere Unterkreisläufe zum Durchlass (73) des kalten Fluids im ersten Bereich (91) und im zweiten Bereich (92) zwischen dem Sammelbehälter zum Eintritt (72) und dem Sammelbehälter zum Austritt (71), wobei die Unterkreisläufe (73) zueinander parallel sind.

12. Hybridvorrichtung (80) nach Anspruch 11, wobei der Sammelbehälter zum Eintritt (72) des kalten Fluids bei einem Modul (10) aus thermoelektrischen Elementen gelegen ist, das dazu bestimmt ist, zuerst mit dem warmen Fluid in Kontakt zu treten, und der Sammelbehälter zum Austritt (71) des kalten Fluids bei einem Abschnitt des zweiten Bereichs (92) gelegen ist, der dazu bestimmt ist, zuletzt mit dem warmen Fluid in Kontakt zu treten.

13. Hybridvorrichtung (80) nach Anspruch 12, wobei der Sammelbehälter zum Eintritt (72) und der Sammelbehälter zum Austritt (71) des kalten Fluids auf einer selben Seite der Vorrichtung (80) gelegen sind.

14. Hybridvorrichtung (80) nach einem der vorhergehenden Ansprüche, wobei mindestens zwei Module (10) aus thermoelektrischen Elementen eine Reihe von Modulen (10) bilden, wobei die Module (10) entlang einer zweiten Richtung (H) voneinander beabstandet sind, die quer zu der ersten Richtung (L) verläuft, der kalte Kreislauf (2) umfassend Rohre bei dem ersten und/oder zweiten Bereich (91, 92) der Vorrichtung (80), die eine Reihe von Rohren bilden, wobei mindestens zwei der Rohre (12, 13) entlang der zweiten Richtung (H) voneinander beabstandet sind.

## Claims

1. Hybrid device (80) comprising, in a first zone (91), thermoelectric elements (3) allowing an electric current to be generated from a temperature gradient applied between two of its active faces (4a, 4p), said device comprising a first circuit (1), referred to as the hot circuit, able to allow the circulation of a first fluid, referred to as hot fluid, and a second circuit (2), referred to as the cold circuit, able to allow the circulation of a second fluid, referred to as cold fluid, of a temperature lower than that of the hot fluid so as to create said gradient, said hybrid device (80) comprising a second zone (92), said second zone comprises a second part (4) of the cold circuit, wherein said hot circuit and the second part of said cold circuit are directly in contact so as to allow an exchange of heat between the cold fluid and the hot fluid, said hybrid device (80) being designed so that the hot fluid passes through it by travelling in a single direction, referred to as first direction (L), said first zone (91) and said second zone (92) being situated in series in the first direction (L), wherein the thermoelectric elements (3) are grouped together into modules (10), at least two of said modules forming a row of modules (10) in which row said modules are spaced apart, and in that adjacent modules (10) of two adjacent rows are offset from one another so that they are arranged in a staggered configuration.

2. Hybrid device (80) according to Claim 1, in which the first zone (91) is situated upstream of the second zone (92) in the first direction (L).

3. Hybrid device (80) according to either one of the preceding claims, in which the first zone (91) and the second zone (92) are thermally and/or electrically insulated.

4. Hybrid device (80) according to any one of the preceding claims, in which the hybrid device comprises secondary exchange surfaces (9) for exchange with the hot fluid, which are situated in the first zone (91) and the second zone (92), the secondary-exchange surfaces (9) situated in the first zone (91) being thermally and/or electrically independent of the secondary-exchange surfaces (9) situated in the second zone (92).

5. Hybrid device (80) according to any one of the preceding claims, in which the hot circuit (1) and the cold circuit (2) are arranged in such a way that the hot fluid flows transversely to the cold fluid in the hybrid device (80).

6. Hybrid device (80) according to any one of the preceding claims, in which said thermoelectric element (3) is of annular shape, a first of said active faces (4a) defined by an external peripheral surface of the thermoelectric element (3) being in a heat-exchange relationship with the hot fluid and a second of said active faces (4b) defined by an interior peripheral surface of the thermoelectric element (3) being in a heat-exchange relationship with the cold fluid.

7. Hybrid device (80) according to any one of the preceding claims, in which a first part (7) of the cold circuit (2) passing through the first zone (91) of the device (80) and a second part (4) of the cold circuit (2) passing through the second zone (92) of the device (80) are independent.

8. Hybrid device (80) according to Claim 7, comprising an inlet header for admitting the cold fluid to the first part (7) of the cold circuit (2), an outlet header for letting the cold fluid out of the first part (7) of the cold circuit (2), an inlet header for admitting the cold fluid to the second part (4) of the cold circuit (2) and an outlet header for letting the cold fluid out of the second part (4) of the cold circuit (2), the first part (7) of the cold circuit (2) and/or the second part (4) of the cold circuit (2) comprising several subcircuits for cold fluid to pass between the inlet header and the outlet header of the first part (7) of the cold circuit (4) and/or between the inlet header and the outlet header of the second part (4) of the cold circuit (2), the subcircuits being parallel to one another.

9. Hybrid device (80) according to Claim 8, in which the first part (7) of the cold circuit (2) and the second part (4) of the cold circuit (2) comprise the same number of subcircuits.

10. Hybrid device (80) according to any one of Claims 1 to 6, in which the first part (7) of the cold circuit (2) passing through the first zone (91) of the device (80) and a second part (4) of the cold circuit (2) passing through the second zone (92) of the device (80) are intended to be passed through in series, in that order.

11. Hybrid device (80) according to Claim 10, comprising an inlet header (72) for admitting the cold fluid to the hybrid device (80) and an outlet header (71) for letting the cold fluid out of the hybrid device (80), the cold circuit (2) comprising several subcircuits (73) for the passage of the cold fluid in the first zone (91) and in the second zone (92) between the inlet header (72) and the outlet header (71), the subcircuits (73) being parallel to one another.

12. Hybrid device (80) according to Claim 11, in which the inlet header (72) for the cold fluid is situated in the region of a module (10) of thermoelectric elements which is intended to come into contact first with said hot fluid, and the outlet header (71) for the cold fluid is situated in the region of a section of the second zone (92) which is intended to come into contact last with said hot fluid.

13. Hybrid device (80) according to Claim 12, in which the inlet header (72) and the outlet header (71) for the cold fluid are situated on one and the same side of the device (80).

14. Hybrid device (80) according to any one of the preceding claims, in which at least two modules (10) of thermoelectric elements form a row of modules (10) in which row said modules (10) are spaced apart in a second direction (H), transverse to the first direction (L), the cold circuit (2) comprising the tubes in the region of said first and/or said second zone (91, 92) of said device (80), forming a row of tubes in which row at least two of said tubes (12, 13) are spaced apart in the second direction (H).
